# EUROPÄISCHE PATENTANMELDUNG

(11) **EP 2 629 115 A1**
(43) Veröffentlichungstag der Anmeldung: **21.08.2013**
(21) Anmeldenummer: 13152800.2
(22) Anmeldetag: 28.01.2013
(51) Int. Cl.: G01S 13/42, G01S 13/87, G01S 13/93, G01S 7/35

(54) **Sensorvorrichtung**

(30) Priorität: 17.02.2012 DE 102012101303
(71) Anmelder: Hella KGaA Hueck & Co., 59552 Lippstadt (DE)
(72) Erfinder: Wixfort, Thomas, 33330 Gütersloh (DE); von Rhein, Andreas, 33154 Salzkotten (DE)

(57) **Zusammenfassung**

Die vorliegende Erfindung betrifft eine Sensorvorrichtung (10) für die Überwachung der Umgebung eines Fahrzeugs (100), aufweisend zumindest zwei Sensoren (20a, 20b) mit jeweils wenigstens einem Signalerzeuger (22a, 22b), einer Sendeantenne (24a, 24b) und jeweils mindestens zwei Empfangsantennen (26a, 26b), dadurch gekennzeichnet, dass wenigstens ein Referenztakterzeuger (30) für das Erzeugen eines gemeinsamen Referenztaktes für die Signalerzeuger (22a, 22b) der zumindest zwei Sensoren (20a, 20b) vorgesehen ist.

## Beschreibung

Die vorliegende Erfindung betrifft eine Sensorvorrichtung für die Überwachung der Umgebung eines Fahrzeugs sowie ein Verfahren für die Überwachung der Umgebung eines Fahrzeugs mit einer Sensorvorrichtung.

Sensorvorrichtungen für die Überwachung der Umgebung eines Fahrzeugs sind bekannt. Sie werden zum Beispiel verwendet, um die Bereiche neben und hinter einem Fahrzeug zu überwachen. Diese Überwachung findet häufig mit elektromagnetischen Signalen, insbesondere in Form von Radarsignalen, statt. Bei der rückwärtigen Überwachung eines Fahrzeugs beziehungsweise bei der seitlichen Überwachung eines Fahrzeugs kommen häufig zwei Sensoren zum Einsatz. Diese sind üblicherweise an den beiden Übergängen der jeweiligen Seite des Fahrzeugs zum Heck des Fahrzeugs angebracht, so dass sie die jeweilige Seite des Fahrzeugs sowie den Heckbereich des Fahrzeugs überwachen können. Diese beiden Sensoren sind miteinander verbunden und als Master- beziehungsweise Slave-Sensor ausgebildet. Das bedeutet, dass einer der beiden Sensoren als Master-Sensor gemeinsame Funktionalitäten aufweist, die er auch dem Slave-Sensor auf der gegenüber liegenden Seite des Fahrzeugs zur Verfügung stellt. Die bekannten Sensoren sind häufig mit einer Sendeantenne und drei Empfangsantennen ausgestattet. Die Empfangsantennen jedes Sensors sind vorzugsweise untereinander phasenstarr gekoppelt, so dass in bekannter Weise eine Winkelmessung der erkannten Objekte stattfinden kann.

Nachteilhaft bei bekannten Sensorvorrichtungen ist es, dass die beiden Sensoren, also der Master-Sensor und der Slave-Sensor, ausschließlich getrennt voneinander eingesetzt werden. Dies führt dazu, dass Objekte, welche sich hinter dem Fahrzeug vorzugsweise mit gleicher Geschwindigkeit und/oder gleichem Abstand bewegen, nicht als zwei separate Objekte wahrgenommen werden können. Dies beruht auf der Tatsache, dass die Anzahl der separat erkennbaren Objekte abhängt von der Anzahl der Empfangsantennen. Insbesondere ist diese Abhängigkeit dergestalt, dass die Hälfte der Anzahl der Empfangsantennen der Zahl der Objekte entspricht, die separat voneinander wahrgenommen werden können. Da bei bekannten Sensoren drei Empfangsantennen zum Einsatz kommen, führt dies dazu, dass theoretisch 1,5 Objekte voneinander separat unterschieden werden können. Da jedoch entweder ein Objekt oder zwei Objekte vorliegen, bringt das Unterscheiden von mathematisch 1,5 Objekten in der Realität nichts, so dass eine Trennfähigkeit bei bekannten Sensorvorrichtungen nicht oder nur in sehr eingeschränktem Maß möglich ist. Die Trennfähigkeit der Sensoren ließe sich nur durch eine bauliche Veränderung in Form weiterer Empfangsantennen erreichen. Dies führt jedoch zu größerer Komplexität des Sensors und höheren Kosten.

Es ist Aufgabe der vorliegenden Erfindung, die voranstehend beschriebenen Nachteile bekannter Sensorvorrichtungen zumindest teilweise zu beheben. Insbesondere ist es Aufgabe der vorliegenden Erfindung, eine Sensorvorrichtung sowie ein Verfahren für die Überwachung der Umgebung eines Fahrzeugs zur Verfügung zu stellen, welche in kostengünstiger und einfacher Weise eine hohe Trennfähigkeit für separate Objekte bei der Überwachung der Umgebung eines Fahrzeugs zur Verfügung stellt.

Die voranstehende Aufgabe wird gelöst durch eine Sensorvorrichtung mit den Merkmalen des unabhängigen Anspruchs 1 sowie durch ein Verfahren mit den Merkmalen des unabhängigen Anspruchs 8. Weitere Merkmale und Details der Erfindung ergeben sich aus den Unteransprüchen, der Beschreibung und den Zeichnungen. Dabei gelten Merkmale und Details, die im Zusammenhang mit der erfindungsgemäßen Sensorvorrichtung beschrieben sind, selbstverständlich auch im Zusammenhang mit dem erfindungsgemäßen Verfahren und jeweils umgekehrt, so dass bezüglich der Offenbarung zu den einzelnen Erfindungsaspekten stets wechselseitig Bezug genommen wird beziehungsweise werden kann.

Eine erfindungsgemäße Sensorvorrichtung dient der Überwachung der Umgebung eines Fahrzeugs. Die Sensorvorrichtung weist zumindest zwei Sensoren mit jeweils einem Signalerzeuger, einer Sendeantenne und jeweils mindestens zwei Empfangsantennen auf. Eine erfindungsgemäße Sensorvorrichtung zeichnet sich dadurch aus, dass wenigstens ein Referenztakterzeuger für das Erzeugen eines gemeinsamen Referenztaktes für die Signalerzeuger der zumindest zwei Sensoren vorgesehen ist.

Der Referenztakterzeuger ermöglicht es, dass eine Kopplung der beiden Sensoren stattfinden kann. Insbesondere werden die beiden Sensoren miteinander phasenstarr gekoppelt, so dass insbesondere ein virtueller gemeinsamer Sensor entsteht. Durch die phasenstarre Kopplung über den Referenztakterzeuger mittels der Vorgabe des gemeinsamen Referenztaktes wird ein virtueller gemeinsamer Sensor zur Verfügung gestellt, welcher dementsprechend auch eine erhöhte Anzahl von Empfangsantennen aufweist. Da bei einer erfindungsgemäßen Sensorvorrichtung jeder der Sensoren zumindest zwei Empfangsantennen aufweist, führt dies zu einem virtuellen gemeinsamen Sensor mit insgesamt mindestens vier Empfangsantennen. Ausgehend von der Möglichkeit der Trennfähigkeit bei der Wahrnehmung von Objekten bei der Überwachung der Umgebung des Fahrzeugs, welche der Hälfte der Anzahl der Empfangsantennen der Sensorvorrichtung entspricht, führt diese virtuelle gemeinsame Verwendung der beiden Sensoren dazu, dass zumindest zwei Objekte separat voneinander erkannt werden können. Im Gegensatz zu der getrennten Verwendung der zwei Sensoren gelingt hier eine Verbesserung hinsichtlich der Trennfähigkeit der Sensorvorrichtung ohne baulichen Eingriff in die Anzahl der Empfangsantennen. Darüber hinaus wird durch das virtuelle Verbinden der beiden Sensoren die Apertur der Sensorvorrichtung vergrößert, so dass sich die Trennfähigkeit im Winkel beim Einsatz der Sensorvorrichtung erhöht.

Dabei ist darauf hinzuweisen, dass bei einer erfindungsgemäßen Sensorvorrichtung der Referenztakterzeuger in unterschiedlicher Weise agieren kann. So ist es möglich, dass er beim Erzeugen des gemeinsamen Referenztaktes für die Signalerzeuger die beiden Sensoren zu einem virtuellen gemeinsamen Sensor kombiniert werden. Werden den beiden Signalerzeugern unterschiedliche Referenztakte zur Verfügung gestellt, so können die beiden Sensoren getrennt voneinander eingesetzt werden. Durch diese Kombination wird es möglich, bei einer erfindungsgemäßen Sensorvorrichtung unterschiedliche Sensorverfahren anzuwenden, ohne dass baulich eine Änderung erfolgen muss. Insbesondere kann während der Überwachung der Umgebung ein Schalten zwischen diesen unterschiedlichen Sensorvarianten, also dem virtuell gemeinsamen Sensor und den getrennten Sensoren, erfolgen. Dies erhöht die Genauigkeit noch weiter, da die Betriebsweise der Sensorvorrichtung insbesondere auf unterschiedliche Verkehrssituationen abgestellt und variiert werden kann. Darüber hinaus kann auch während einer Verkehrssituation flexibel zwischen den beiden Sensorkonfigurationen gewechselt werden, so dass aus der Kombination der Ergebnisse beider Sensorbetriebsweisen eine verbesserte Information über Objekte bei der Überwachung der Umgebung des Fahrzeugs zur Verfügung gestellt wird.

Bei einer erfindungsgemäßen Sensorvorrichtung werden bei den Signalerzeugern vorzugsweise elektromagnetische Signale, insbesondere Radarsignale, erzeugt. Der Referenztakt wird vorzugsweise in einem Bereich von kleiner als circa 10 MHz, insbesondere im Bereich von circa 8 MHz vorgegeben. Darüber hinaus entspricht der Abstand zwischen den beiden Sensoren vorzugsweise circa dem Abstand zwischen den beiden Seiten des Fahrzeugs, also circa der Fahrzeugbreite. Auch bei einer solchen erfindungsgemäßen Sensorvorrichtung sind die beiden Sensoren vorzugsweise an den beiden Übergängen zwischen der jeweiligen Seite des Fahrzeugs und dem Heck des Fahrzeugs angebracht. Damit wird eine Überwachung hinter dem Fahrzeug, wie auch neben den beiden Seiten des Fahrzeugs, durch eine erfindungsgemäße Sensorvorrichtung möglich.

Eine erfindungsgemäße Sensorvorrichtung kann dahingehend weitergebildet werden, dass wenigstens einer der Sensoren, insbesondere alle Sensoren, zumindest drei Empfangsantennen aufweisen. Vorzugsweise weisen alle Sensoren die gleiche Anzahl von Empfangsantennen auf, so dass bei der Konfiguration als gemeinsamer Sensor eine Anzahl von Empfangsantennen entsteht, welche durch zwei teilbar ist. Dies führt bei einem Sensorbetrieb über den Referenztakterzeuger mit einem gemeinsamen Referenztakt zu einem virtuellen gemeinsamen Sensor mit insgesamt sechs Empfangsantennen, so dass bis zu zumindest drei Objekten separat wahrgenommen werden können.

Vorteilhaft kann es auch sein, wenn bei einer erfindungsgemäßen Sensorvorrichtung zumindest zwei Sensoren jeweils einen eigenen Referenztakterzeuger für die Erzeugung unterschiedlicher und/oder gemeinsamer Referenztakte für die Signalerzeuger dieser beiden Sensoren aufweisen. Insbesondere sind insgesamt zumindest zwei Referenztakterzeuger vorgesehen. Diese ermöglichen es, dass für jeden der beiden Sensoren ein eigener Referenztakt erzeugt und vorgegeben wird. Dabei kann einer der beiden Referenztakterzeuger als erfindungsgemäßer Referenztakterzeuger für das Vorgeben eines gemeinsamen Referenztaktes ausgebildet sein. Jedoch ist es auch möglich, dass ein separater (dritter) gemeinsamer Referenztakterzeuger vorgesehen ist, der den gemeinsamen Referenztakt vorgibt und unabhängig von den jeweils spezifisch für den jeweiligen Sensor angeordneten Referenztakterzeugern ausgebildet ist.

Durch diese Ausführungsform wird es möglich, dass in einfacher und kostengünstiger Weise ein Umschalten zwischen unterschiedlichen Konfigurationen möglich ist. Durch das Verwenden der beiden spezifischen Referenztakterzeuger wird eine spezifische Sensorkonfiguration möglich, so dass der jeweilige Sensor für sich alleine die Umgebung überwacht. Wird erfindungsgemäß ein gemeinsamer Referenztakt vorgegeben, so werden die beiden Sensoren virtuell zusammengelegt zu einem virtuellen gemeinsamen Sensor.

Das Umschalten zwischen diesen Betriebsweisen getrennter und virtueller gemeinsamer Referenztakte kann auch in Bezug auf die jeweilige Umgebungssituation erfolgen. Insbesondere kann beispielsweise bei einer Vielzahl von Objekten in der Umgebung, zum Beispiel im Verkehr auf einer Autobahn, die gemeinsame Referenztaktung durchgeführt werden, während zum Beispiel in verkehrsärmeren Situationen, wie auf einer Landstraße, die getrennte Referenztaktung, also die separate Betriebsweise der beiden Sensoren durchgeführt wird. Auch eine vordefinierte Variation zwischen gemeinsamer und getrennter Referenztaktung ist möglich, so dass auf diese Weise eine Diversifizierung der Messsignale erzeugt wird. Aus der Erhöhung der Anzahl der unterschiedlichen Informationen kann ein detaillierteres Umfeldmodell erzeugt werden, so dass ohne eine bauliche Veränderung der Sensorvorrichtung eine verbesserte Informationsauswertung möglich wird.

Vorteilhaft kann es auch sein, wenn bei einer erfindungsgemäßen Sensorvorrichtung die Signalerzeuger der zumindest zwei Sensoren direkt mit dem wenigstens einen Referenztakterzeuger in signalkommunizierendem Kontakt stehen. Das bedeutet, dass von beiden Sensoren eine Signalleitung (in kabelgebundener oder kabelloser Weise) zu einem gemeinsamen Referenztakterzeuger besteht. Insbesondere wird für den Referenztaktgeber ein eigenes Kabel vorgesehen, welches zu beiden Sensoren führt. Damit kann der gemeinsame Referenztakterzeuger auch in ein einem der beiden Sensoren angeordnet sein und trotzdem mit dem zweiten Sensor, insbesondere mit dessen Signalerzeuger, in Verbindung stehen. Bei der Variante mit separaten Referenztakterzeugern für jeden Sensor ist durch das zusätzliche Kabel das im voranstehenden Absatz beschriebene Umschalten zwischen einer gemeinsamen und einer getrennten Referenztaktung möglich.

Vorteilhaft ist es auch, wenn bei einer erfindungsgemäßen Sensorvorrichtung die Signalerzeuger der zumindest zwei Sensoren ausgebildet sind, für die Erzeugung von vordefinierten Frequenzunterschieden der Sendesignale über deren zeitlichen Verlauf. Das bedeutet, dass im Signalerzeuger zum Beispiel die Variation der Frequenz des ausgesendeten Signals durchgeführt wird. Insbesondere handelt es sich hierbei um eine Modulation der Frequenz. Insbesondere wird ein schrittweises Verändern, vorzugsweise ein schrittweises Anheben, der Frequenz durchgeführt, so dass stufenweise Signale mit vordefinierter Frequenzabstandsweite ausgesendet werden. Diese erzeugten Signalstufen können auch als "chirps" bezeichnet werden. Vorzugsweise werden diese Stufen wiederholt, so dass nach einer definierten Anzahl von Stufen, zum Beispiel 256 Stufen, die Variation von vorne durchgeführt wird. Selbstverständlich kann auch eine lineare Variation der Sendesignale erzeugt werden. Auch das verschachtelte Versenden von mehreren Sendesignalen, also das Verschachteln von "Chirps", ist im Rahmen der vorliegenden Erfindung möglich.

Bei der voranstehend beschriebenen Ausführungsform kann es von Vorteil sein, wenn zumindest eine Synchronisationsvorrichtung für die Signalerzeuger der zumindest zwei Sensoren vorgesehen ist, um die Variation der Sendesignale der zumindest zwei Sensoren zu synchronisieren. Insbesondere erfolgt dies mithilfe eines Start-Triggers. Dies kann in einer gemeinsamen Synchronisationsvorrichtung für die beiden Signalerzeuger durchgeführt werden. So werden insbesondere unerwünschte Phasenverschiebungen bei der Variation der vordefinierten Frequenzunterschiede vermieden. So kann erreicht werden, dass ein Fehler durch solche Phasenverschiebungen bei der Auswertung der empfangenen Signale durch die Empfangsantennen ausgeschlossen ist.

Vorteilhaft ist es auch, wenn bei einer erfindungsgemäßen Sensorvorrichtung der Referenztakterzeuger für die Erzeugung von vordefinierten Frequenzunterschieden des gemeinsamen Referenztaktes über dessen zeitlichen Verlauf ausgebildet ist. Diese Ausführungsform kann alternativ oder zusätzlich zu der Ausführungsform der beiden voranstehenden Absätze durchgeführt werden. Der Signalerzeuger jedes Sensors kann bei dieser Ausführungsform vorzugsweise in rein transformierender Weise ausgebildet sein, so dass die Variation für die Erzeugung vordefinierter Frequenzunterschiede vorzugsweise ausschließlich im gemeinsamen Referenztakterzeuger stattfindet. Dies reduziert die Kosten der einzelnen Signalerzeuger. Diese transformieren den gemeinsamen Referenztakt in die gewünschte Sendesignalstärke beziehungsweise den gewünschten Sendesignalbereich, so dass auf diese Weise auch ein schnelleres Erzeugen der Signale möglich wird. Auch wird bei dieser Ausführungsform eine Synchronisation unerheblich, da die Variation der Frequenzunterschiede gemeinsam für alle Sensoren durchgeführt wird. Dies reduziert Kosten und Aufwand einer erfindungsgemäßen Sensorvorrichtung weiter.

Ein weiter Gegenstand der vorliegenden Erfindung ist ein Verfahren für die Überwachung eines Fahrzeugs mit einer Sensorvorrichtung, aufweisend zumindest zwei Sensoren mit jeweils wenigstens einem Signalerzeuger, einer Sendeantenne und jeweils mindestens zwei Empfangsantennen. Ein erfindungsgemäßes Verfahren zeichnet sich dadurch aus, dass für die Signalerzeuger der zumindest zwei Sensoren ein gemeinsamer Referenztakt vorgegeben wird. Insbesondere erfolgt diese Vorgabe durch einen gemeinsamen Referenztakterzeuger. Ein erfindungsgemäßes Verfahren ist vorzugsweise derart ausgebildet, dass es bei einer erfindungsgemäßen Sensorvorrichtung eingesetzt wird. Damit bringt ein erfindungsgemäßes Verfahren die gleichen Vorteile mit sich, wie sie ausführlich mit Bezug auf eine erfindungsgemäße Sensorvorrichtung erläutert worden sind.

Ein erfindungsgemäßes Verfahren kann dahingehend weitergebildet werden, dass, insbesondere in Abhängigkeit der Verkehrsdichte um das Fahrzeug herum, entweder ein gemeinsamer Referenztakt oder eine separate Taktung für den Signalerzeuger der zumindest zwei Sensoren vorgegeben wird. Dabei handelt es sich insbesondere um ein Umschalten zwischen einer gemeinsamen Betriebsweise der Sensoren und einer separaten Betriebsweise der Sensoren der Sensorvorrichtung. Das Umschalten erfolgt insbesondere in Abhängigkeit von der tatsächlichen Verkehrssituation, so dass zum Beispiel in Abhängigkeit von der Geschwindigkeit ein Rückschluss auf die aktuelle Verkehrssituation gezogen werden kann. Auch Informationen aus einem Navigationssystem können herangezogen werden, um zum Beispiel festzustellen, ob sich das Fahrzeug auf einer Autobahn, einer Landstraße oder im Stadtverkehr befindet. Je höher die Verkehrsdichte ist, umso vorteilhafter ist es, wenn eine Betriebsweise mit gemeinsamem Referenztakt verwendet wird. Sinkt die Verkehrsdichte, so kann es vorteilhaft sein, die Betriebsweise mit separater Taktung durchzuführen, um eine verbesserte Winkeleindeutigkeit zur Verfügung stellen zu können.

Die voranstehend beschriebene Erfindung wird näher erläutert anhand der beigefügten Zeichnungsfiguren. Die dabei verwendeten Begrifflichkeiten "links", "rechts", "oben" und "unten" beziehen sich auf eine Ausrichtung der Zeichnungsfiguren mit normal lesbaren Bezugszeichen. Es zeigen schematisch:
- Figur 1: eine erste Ausführungsform einer erfindungsgemäßen Sensorvorrichtung,
- Figur 2: eine weitere Ausführungsform einer erfindungsgemäßen Sensorvorrichtung,
- Figur 3: eine Ausführungsform einer erfindungsgemäßen Sensorvorrichtung an einem Fahrzeug,
- Figur 4a: eine Verkehrssituation mit einer Betriebsweise mit getrennten Sensoren und
- Figur 4b: eine Verkehrssituation gemäß Fig. 4a mit einer Betriebsweise mit gemeinsamen Sensoren.

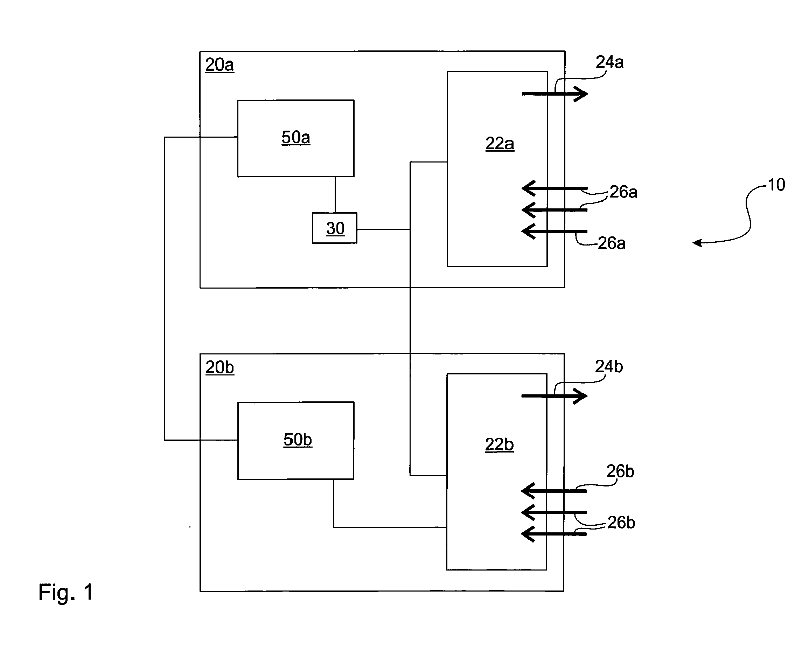

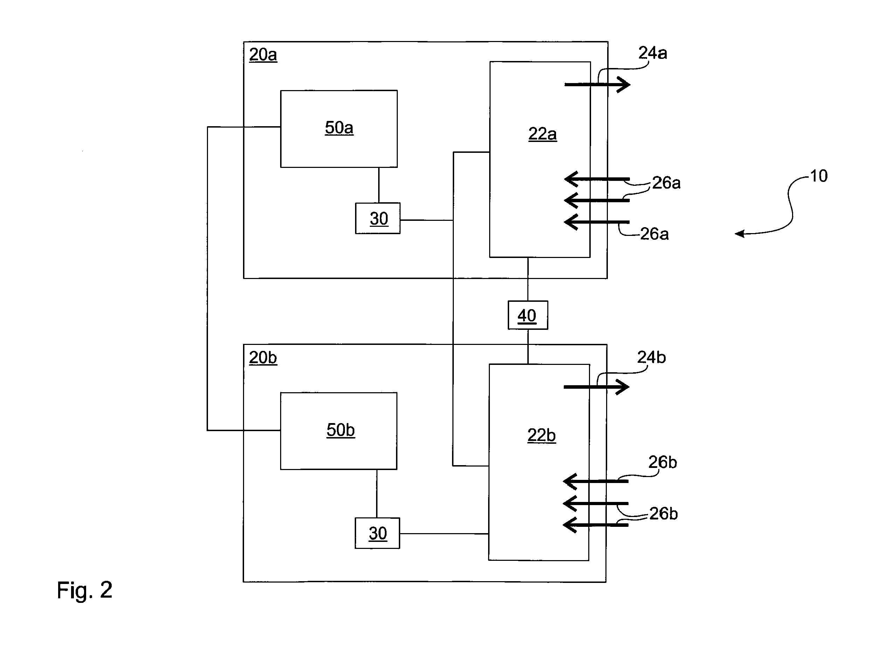

Die Fig. 1 und 2 zeigen zwei verschiedene Ausführungsformen einer erfindungsgemäßen Sensorvorrichtung 10. Beiden Sensorvorrichtungen 10 ist es gemeinsam, dass sie jeweils einen ersten Sensor 20a und einen zweiten Sensor 20b aufweisen. Darüber hinaus ist jeder Sensor 20a und 20b jeweils mit einem ersten Prozessor 50a beziehungsweise einem zweiten Prozessor 50b ausgestattet. Ebenfalls weist jeder Sensor 20a eine erste Sendeantenne 24a beziehungsweise eine zweite Sendeantenne 24b auf. Auch ist jeder Sensor 20a und 20b mit drei ersten Empfangsantennen 26a beziehungsweise drei zweiten Empfangsantennen 26b ausgestattet. Alle Antennen stehen in Kontakt mit einem ersten Signalerzeuger 22a beziehungsweise einem zweiten Signalerzeuger 22b.

In beiden Ausführungsformen der Fig. 1 und der Fig. 2 für eine Sensorvorrichtung 10 ist zumindest ein Referenztakterzeuger 30 vorgesehen. Dieser steht in signalkommunizierender Verbindung mit dem ersten Signalerzeuger 22a und dem zweiten Signalerzeuger 22b. Über diesen Referenztakterzeuger 30, welcher insbesondere ein gemeinsamer Referenztakterzeuger 30 ist, wird ein gemeinsamer Referenztakt für beide Signalerzeuger 22a und 22b zur Verfügung gestellt beziehungsweise erzeugt. Damit wird in Abhängigkeit des gemeinsamen Referenztaktes, insbesondere gemäß einer phasenstarren Kopplung, in den beiden Signalerzeugern 22a und 22b jeweils ein Signal erzeugt, welches über die erste Sendeantenne 24a beziehungsweise die zweite Sendeantenne 24b ausgesendet wird. Damit erfolgt eine Kopplung der beiden Sensoren 20a und 20b, so dass über den gemeinsamen Referenztakt des Referenztakterzeugers 30 die beiden Sensoren 20a und 20b virtuell zusammengelegt worden sind. Sie verfügen somit als ein virtueller gemeinsamer Sensor über zwei Sendeantennen 24a und 24b sowie insgesamt sechs Empfangsantennen 26a und 26b.

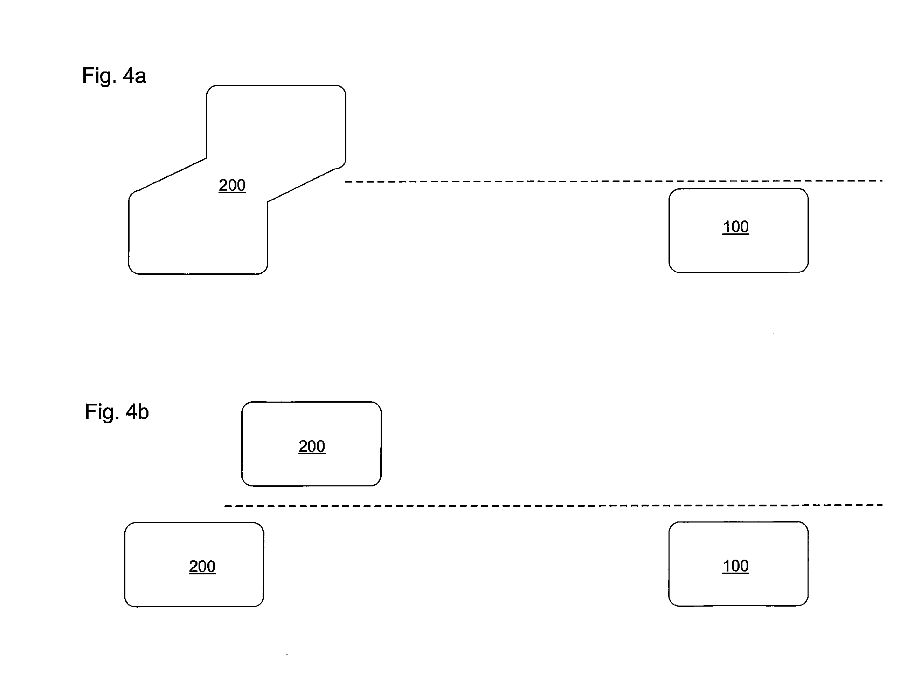

Durch die Konfiguration, wie sie voranstehend erläutert worden ist, kann eine Verbesserung hinsichtlich der Trennfähigkeit der wahrgenommenen Objekte erzielt werden. Dies wird anhand der Fig. 4a und 4b verdeutlicht. So zeigt Fig. 4a die Situation, bei welcher die beiden Sensoren 20a und 20b getrennt voneinander betrieben werden. So wird bei der Überwachung der Umgebung des Fahrzeugs 100 ein Objekt 200 hinter dem Fahrzeug 100 erkannt, welches als ein gemeinsames Objekt 200 mit einem einzigen Abstand und einer einzigen Geschwindigkeit erkannt wird. Wird jedoch eine Sensorvorrichtung 10 in erfindungsgemäßer Weise mit einem gemeinsamen Referenztakt eines gemeinsamen Referenztakterzeugers 30 betrieben, so ist durch das Zusammenschalten aller Empfangsantennen 26a und 26b die Separate Wahmehmung der einzelnen Objekte 200 möglich. So konnte durch diese virtuelle Zusammenlegung der beiden Sensoren 20a und 20b eine Trennung der Objekte 200 in die reale Situation erfolgen, so dass nunmehr die beiden Objekte 200, oben und unten in Fig. 4b getrennt voneinander und dargestellt, erkannt werden können.

In Fig. 2 ist die Ausführungsform der Sensorvorrichtung 10 gegenüber der Ausführungsform der Fig. 1 dahingehend weitergebildet, dass der zweite Sensor 20 einen eigenen Referenztakterzeuger 30 aufweist. So kann diese Sensorvorrichtung 10 auch in konventioneller Weise betrieben werden, so dass der jeweilige Referenztakterzeuger 30 des jeweiligen Sensors 20a und 20b nur beziehungsweise ausschließlich für den eigenen Signalerzeuger 22a beziehungsweise 22b einen Referenztakt zur Verfügung stellt. Dies entspricht der getrennten Betriebsweise der beiden Sensoren 20a und 20b.

Ebenfalls in Fig. 2 ist zu erkennen, dass eine Synchronisationsvorrichtung 40 vorgesehen ist, die bei einer Frequenzvariation der beiden Signalerzeuger 22a und 22b eine Synchronisation der Frequenzvariation durchführt. Diese Synchronisation erfolgt insbesondere durch einen Start-Trigger. Damit können Phasenverschiebungen beim Senden über die beiden Sendeantennen 24a und 24b vermieden werden. Wird ein gemeinsamer Referenztakterzeuger 30 auch dazu verwendet, um solche Frequenzunterschiede durchzuführen, so reicht es auch, wenn die beiden Signalerzeuger 22a und 22b eine Transformation des Referenztaktes durchführen. Demnach erfolgt in den beiden Signalerzeugern 22a und 22b die Erzeugung der Signale auf Basis des Referenztaktes, zum Beispiel auf Basis von circa 8MHz. Diese Referenzbasis dient der Erzeugung des tatsächlichen Sendesignals, welches im Hochfrequenzbereich erzeugt wird. In einem solchen Fall muss keine Synchronisationsvorrichtung 40 verwendet werden.

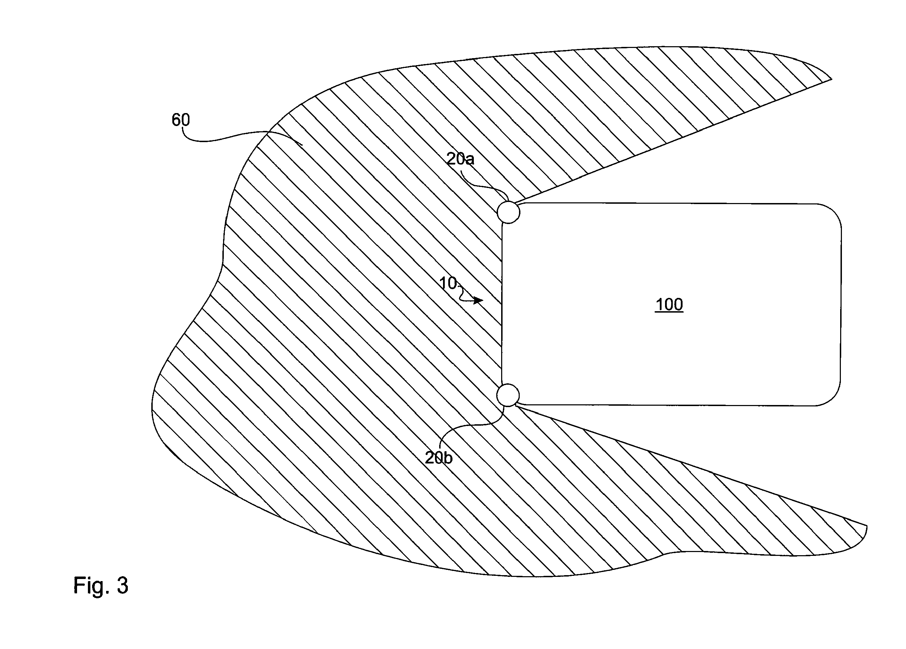

Fig. 3 zeigt schematisch die Anordnung der Sensoren 20a und 20b einer Sensorvorrichtung 10 an einem Fahrzeug 100. Diese Sensoren 20a und 20b sind an den Übergangsbereichen zwischen den beiden Seiten des Fahrzeugs 100 zum Heck des Fahrzeugs 100 angeordnet. In schraffierter Weise ist der überwachte Bereich 60 dargestellt, so dass eine Überwachung des Fahrzeugs zu beiden Seiten und hinter dem Heck des Fahrzeugs 100 durchgeführt werden kann.

Die voranstehenden Erläuterungen der Ausführungsformen beschreiben die vorliegende Erfindung nur im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 10: Sensorvorrichtung
- 20a: Erster Sensor
- 20b: Zweiter Sensor
- 22a: Erster Signalerzeuger
- 22b: Zweiter Signalerzeuger
- 24a: Erste Sendeantenne
- 24b: Zweite Sendeantenne
- 26a: Erste Empfangsantenne
- 26b: Zweite Empfangsantenne
- 30: Referenztakterzeuger
- 40: Synchronisationsvorrichtung
- 50a: Erster Prozessor
- 50b: Zweiter Prozessor
- 60: Überwachter Bereich

- 100: Fahrzeug
- 200: Objekt

## Patentansprüche

1. Sensorvorrichtung (10) für die Überwachung der Umgebung eines Fahrzeugs (100), aufweisend zumindest zwei Sensoren (20a, 20b) mit jeweils wenigstens einem Signalerzeuger (22a, 22b), einer Sendeantenne (24a, 24b) und jeweils mindestens zwei Empfangsantennen (26a, 26b), **dadurch gekennzeichnet, dass** wenigstens ein Referenztakterzeuger (30) für das Erzeugen eines gemeinsamen Referenztaktes für die Signalerzeuger (22a, 22b) der zumindest zwei Sensoren (20a, 20b) vorgesehen ist.

2. Sensorvorrichtung (10) nach Anspruch 1, **dadurch gekennzeichnet, dass** wenigstens einer der Sensoren (20a, 20b), insbesondere alle Sensoren (20a, 20b), zumindest drei Empfangsantennen (26a, 26b) aufweist.

3. Sensorvorrichtung (10) nach einem der vorangegangenen Ansprüche, **dadurch gekennzeichnet, dass** zumindest zwei Sensoren (20a, 20b) jeweils einen eigenen Referenztakterzeuger (30) für die Erzeugung unterschiedlicher Referenztakte für die Signalerzeuger (22a, 22b) dieser beiden Sensoren (20a, 20b) aufweisen.

4. Sensorvorrichtung (10) nach einem der vorangegangenen Ansprüche, **dadurch gekennzeichnet, dass** die Signalerzeuger (22a, 22b) der zumindest zwei Sensoren (20a, 20b) direkt mit dem wenigstens einen Referenztakterzeuger (30) in signalkommunizierendem Kontakt stehen.

5. Sensorvorrichtung (10) nach einem der vorangegangenen Ansprüche, **dadurch gekennzeichnet, dass** die Signalerzeuger (22a, 22b) der zumindest zwei Sensoren (20a, 20b) ausgebildet sind für die Erzeugung von vordefinierten Frequenzunterschieden der Sendesignale über deren zeitlichen Verlauf.

6. Sensorvorrichtung (10) nach Anspruch 5, **dadurch gekennzeichnet, dass** zumindest eine Synchronisationsvorrichtung (40) für die Signalerzeuger (22a, 22b) der zumindest zwei Sensoren (20a, 20b) vorgesehen ist, um die Variation der Sendesignale der zumindest zwei Sensoren (20a, 20b) zu synchronisieren.

7. Sensorvorrichtung (10) nach einem der vorangegangenen Ansprüche, **dadurch gekennzeichnet, dass** der Referenztakterzeuger (30) ausgebildet ist für die Erzeugung von vordefinierten Frequenzunterschieden des gemeinsamen Referenztaktes über dessen zeitlichen Verlauf.

8. Verfahren für die Überwachung der Umgebung eines Fahrzeugs (100) mit einer Sensorvorrichtung (10), aufweisend zumindest zwei Sensoren (20a, 20b) mit jeweils wenigstens einem Signalerzeuger (22a, 22b), einer Sendeantenne (24a, 24b) und jeweils mindestens zwei Empfangsantennen 26a, 26b), **dadurch gekennzeichnet, dass** für die Signalerzeuger (22a, 22b) der zumindest zwei Sensoren (20a, 20b) ein gemeinsamer Referenztakt vorgegeben wird.

9. Verfahren nach Anspruch 8, **dadurch gekennzeichnet, dass** es bei einer Sensorvorrichtung (10) mit den Merkmalen eines der Ansprüche 1 bis 7 eingesetzt wird.

10. Verfahren nach einem der Ansprüche 8 oder 9, **dadurch gekennzeichnet, dass,** insbesondere in Abhängigkeit der Verkehrsdichte um das Fahrzeug (100), entweder ein gemeinsamer Referenztakt oder eine separate Taktung für die Signalerzeuger (22a, 22b) der zumindest zwei Sensoren (20a, 20b) vorgegeben wird.
